(19) Europäisches Patentamt / European Patent Office / Office européen des brevets

(11) **EP 1 444 874 B1**

(12) **EUROPÄISCHE PATENTSCHRIFT**

(45) Veröffentlichungstag und Bekanntmachung des Hinweises auf die Patenterteilung:
**29.04.2015 Patentblatt 2015/18**

(21) Anmeldenummer: **02785225.0**

(22) Anmeldetag: **17.10.2002**

(51) Int Cl.:
*H05H 1/46* (2006.01)      *H01J 37/32* (2006.01)

(86) Internationale Anmeldenummer:
**PCT/EP2002/011601**

(87) Internationale Veröffentlichungsnummer:
**WO 2003/043390 (22.05.2003 Gazette 2003/21)**

(54) **EINRICHTUNG ZUR ERZEUGUNG EINES LOKALEN ELEKTRON-ZYKLOTRONMIKROWELLEN-NIEDERDRUCKPLASMAS AN EINEM VORGEBBAREN ORT INNERHALB DER PROZESSKAMMER**

SYSTEM FOR GENERATING A LOCAL ELECTRON-CYCLOTRON MICROWAVE LOW-PRESSURE PLASMA AT A PREDETERMINED LOCATION WITHIN THE PROCESSING CHAMBER OF SAID SYSTEM

SYSTEME PERMETTANT DE PRODUIRE UN PLASMA LOCAL MICRO-ONDES A BASSE PRESSION A LA RESONANCE ELECTRONIQUE CYCLOTRONIQUE DANS UN EMPLACEMENT PREDEFINI A L'INTERIEUR DE LA CHAMBRE DE TRAITEMENT DUDIT SYSTEME

(84) Benannte Vertragsstaaten:
**DE FR GB IT**

(30) Priorität: **17.11.2001 DE 10156615**

(43) Veröffentlichungstag der Anmeldung:
**11.08.2004 Patentblatt 2004/33**

(73) Patentinhaber: **Karlsruher Institut für Technologie**
**76131 Karlsruhe (DE)**

(72) Erfinder:
• **ULRICH, Sven**
  **76297 Stutensee (DE)**
• **STÜBER, Michael**
  **76829 Landau (DE)**
• **LEISTE, Harald**
  **76356 Weingarten (DE)**

• **NIEDERBERGER, Lorenz**
  **76135 Karlsruhe (DE)**
• **SELL, Konrad**
  **76133 Karlsruhe (DE)**
• **LATTEMANN, Martina**
  **72072 Tübingen (DE)**
• **LOOS, Roland**
  **78120 Furtwangen (DE)**

(74) Vertreter: **Gärtner, Stephan et al**
  **Karlsruher Institut für Technologie**
  **Stabsabteilung Innovation**
  **Postfach 36 40**
  **76021 Karlsruhe (DE)**

(56) Entgegenhaltungen:
  **US-A- 5 115 167      US-A- 5 954 882**
  **US-A1- 2001 008 798**

**Beschreibung**

Die Erfindung betrifft eine Einrichtung zur Erzeugung eines Elektron-Zyklotron-Mikrowellen-Niederdruckplasmas innerhalb einer Prozesskammer der Einrichtung. Mit diesem Plasma kann die Oberfläche eines exponierten Substrats geätzt, modifiziert, mit einer Substanz beschichtet werden oder strukturiert werden.

Solche Einrichtungen/Anlagen sind in der plasmaunterstützten Schichtherstellung und Oberflächenbehandlung von zentraler Bedeutung. Die Mikrowellenleistung wird gepulst oder kontinuierlich eingekoppelt, wie schließlich, hängt vom Behandlungsprozess bzw. Einbringprozess in ein exponiertes Substrat ab. Ein Beschichtungsprozess, beispielsweise Magnetronsputtern, Verdampfen oder Arc-Verdampfen, wird dadurch unterstützt, als vor das zu beschichtende Substrat ein Plasma projiziert wird. Weiterhin kann ein Substrat oder eine Substratoberfläche etwa folgendermaßen modifiziert werden:

indem die Oberfläche oxidiert oder auch in das Substrat hinein oxidiert wird, das kann mit einem Sauerstoff- oder Edelgas/Sauerstoff-Plasma durchgeführt werden;
indem die Oberfläche nitriert oder auch in das Substrat bis mehrere 100 μm hinein nitriert wird, das kann mit einem Stickstoff- oder Edelgas/Stickstoff-Plasma durchgeführt werden; indem die Oberfläche boriert oder auch in das Substrat hinein boriert wird, das kann mit einem Chlor-Borid-, Fluor-Borid- oder Edelgas/Clor-Borid-Plasma, einem borhaltigen Gas-Plasma oder borhaltigen Edelgas-Plasma durchgeführt werden, aber auch aus einer Kombination der drei genannten Möglichkeiten.

In der WO 96/23318 wird ein Plasmareaktor beschrieben, der zur Erzeugung und zum Unterhalten eines Plasmas in einem Hohlraumresonator vorgesehen ist. Dieser Reaktor wird u.a. in der Dünnschichttechnologie verwendet. Damit sind Hartstoffschichten, insbesondere Diamantschichten, herstellbar, in der Materialsynthese Plasmapolimerisations- und Pulversyntheseprozesse und in der Plasmaoberflächenbehandlung Nitrier- und Ätzbehandlungen durchführbar. Der Querschnitt des Hohlraumresonators ist im Scheitelbereich verjüngt. Die Wand des Hohlraumresonators ist in den Scheitelbereichen soweit geschlossen, dass eine angeregte Feldmode im Bereich der Querschnittsverengungen Hauptmaxima aufweist, deren Maximalfeldstärke gegenüber den Feldstärken benachbarter Nebenmaxima überhöht ist. Im Bereich eines Hauptmaximums ist eine Reaktionseinheit mit einem zu bearbeitenden Substrat, das aus der Gasphase beschichtet wird. Prozessparameter wie Gasdruck und eingekoppelte magnetische Leistung sind bei einer stabilen Lage des Plasmas weitestgehend unabhängig voneinander wählbar, ohne dass es zu einer unerwünschten Zündung des Plasmas in den Nebenmaxima der Feldstärkeverteilung im Resonator kommt. Die Hauptmaxima der Feldstärkeverteilung sollen so überhöht sein, dass es nur dort zu einer Plasmazündung kommt.

Der Hohlraumresonator des Reaktors weist eine solche feste Geometrie auf, dass wenigstens zwei plasmazündungsfähige Hauptmaxima in der Feldstärkeverteilung auftreten. Sie müssen gegenüber den übrigen Maxima entsprechend deutlich überhöht sein. Eine solche Resonatorgeometrie ist das vollständige Ellipsoid oder zwei Paraboloidteile jeweils mit Scheitel, die über ein zylindrisches Zwischenstück miteinander zum Hohlraumresonator geschlossen sind. Im jeweils einen Brennpunkt der Hohlraumgeometrie wird die Mikrowelle eingespeist, im andern befindet sich das Zentrum der Plasmabildung bzw. der Last. Die Plasmabildung wird über Strahlfokussierung und ohne Magnetfeldeinfluss erzeugt und ist deshalb an eine starre Resonatorgeometrie bzw. zwei solche Hauptmaxima als einmal Quelle und zum andern Mal Senke gebunden.

*In der* US 5,115,167 *wird ein Plasma-Prozessor beschrieben. Dieser besteht aus einer Mikrowellenquelle 7 mit Wellenleiter 5 und einer Abstrahleinrichtung/Antenne. Die abgestrahlte Mikrowelle trifft auf einem Mikrowellenspiegel 16, dessen schalenartige Reflexionsfläche Teil einer offenen konischen Fläche mit einem Scheitelpunkt ist. Die Reflexionsfläche hat einen von dem Mikrowellenspiegel 15 überdeckten Brennpunkt, mit dem der im Brennpunkt 15 über die Antenne 17 abgestrahlte Mikrowellenstrahl zu* einem Parallelstrahl reflektiert wird. Sie besteht weiter aus einem Substrathalter 10 im Strahlengang des am Mikrowellenspiegel 16 reflektierten Mikrowellenstrahls, in dem ein eingespanntes Substrat 11 mit ausgesuchter Fläche in den reflektierten Mikrowellenstrahl exponierbar ist. Die Mikrowelle tritt durch ein mikrowellentransparentes oder die Transmission nicht nennenswert beeinträchtigendes Fenster, dem Mikrowellenfenster 14, das zwischen der Antenne 17 und vor dem Substrathalter 10 in der Wand der Prozesskammer 1 sitzt. Die Prozesskammer 1 ist evakuierbar. In ihr ist der Substrathalter 10 aufgestellt. Zur Erzeugung eines Mikrowellenplasmas 13 darin kann die Prozesskammer mit einem ausgewählten Gas bis* zu einer vorgegebenen *Dichte und einem vorgegebenen Druck p geflutet werden kann. Eine Einheit 3 zum Erzeugen eines räumlich ausgedehnten Bereichs eines zeitlich konstanten magnetischen Flusses oder eines zeitlich schwankenden magnetischen Flusses, welcher sich zwischen dem Substrathalter 10 und dem Mikrowellenfenster 14 befindet und dort von dem reflektierten Mikrowellenstrahl 18 in der Prozesskammer 1 durchdrungen wird, ist angebaut. Die Einheit zum Erzeugen des vom reflektierten Mikrowellenstrahl durchdrungenen Magnetfelds, ein Solenoid, sitzt in dem Plasma-Prozessor so, dass die Magnetfeldachse parallel zur Strahlachse des reflektierten Mikrowellenstrahls sitzt, bzw. mit ihr zusammenfällt.*

Der Erfindung liegt die Aufgabe zugrunde, ein Elektron-Zyklotron-Resonanz-Mikrowellenplasma in einer Vakuumapparatur zu erzeugen und den Ort des Mikrowellenplasmas variieren zu können.

Die Aufgabe wird durch eine Einrichtung zur Erzeugung eines lokalen Elektron-Zyklotron-Resonanz-Mikrowellen-Niederdruckplasmas gemäß den *kennzeichnenden* Merkmalen des Anspruchs 1 *und des damit betreibbaren Verfahrens zur Erzeugung des lokalen Plasmas nach Anspruch 18* gelöst. Die Einrichtung wird als Elektron-Zyklotron-Resonanz-Mikrowellenniederdruckplasma-Projektionseinheit, abgekürzt in der Fachsprache: (Electron-Cyclotron-Resonance) ECR-MP, bezeichnet.

Sie besteht *aus einer Einheit 3 oder Einheiten 3 zur Erzeugung des jeweiligen Magnetfelds entlang der Strahlachse 8 des reflektierten Mikrowellenstrahls 18 oder der Strahlachse 8 des in Wechselwirkung tretenden jeweiligen Strahlausschnitts, die verstellt werden kann oder können.*

*Hierbei ist im Gegensatz zum Stande der Technik entscheidend, dass die im Freien verlaufende, mindestens eine Magnetfeldachse 9 die Strahlachse 8 des Mikrowellenstrahls 18 kreuzt und nicht parallel zur Strahlachse 8 des Mikrowellenstrahls liegt oder gar mit ihm zusammenfällt (siehe US 5,115,167).*

*Sind mindestens zwei Einheiten 3 zum Erzeugen jeweils eines räumlich ausgedehnten Bereichs eines zeitlich konstanten magnetischen Flusses $B_0$ oder eines zeitlich schwankenden magnetischen Flusses $B_0$ + B(t) vorhanden, liegen die jeweiligen Kreuzungsvolumina 13 aus Magnetfeld und Mikrowellenstrahl im Strahlengang 18 der Mikrowelle nicht hintereinander.*

*Im jeweiligen Kreuzungsvolumen 13 von Mikrowellenstrahl 18 und Magnetfeld ist die magnetische Induktion $B_0$ in einem Volumen von mindestens 0,5 cm$^3$ so stark, dass die eingestrahlte Mikrowelle 18 mit der Erregerfrequenz $\omega_E$ gleich oder nahezu gleich der Elektron-Zyklotron-Frequenz*

$$\omega_{ez} = e_0/m_e * B$$

*ist. Wobei eo die Elementarladung und $m_e$ der Elektronenmasse ist. Somit besteht die Elektron-Zyklotron-Resonanzbedingung, bzw. besteht sie nahezu.*

*Damit ist in dem mindestens einen Kreuzungsvolumen 13 von Mikrowellenstrahl 18 und Magnetfeld ein lokales Elektron-Zyklotron-Mikrowellen-Niederdruckplasmas an einem vorgebbaren Ort innerhalb der Prozesskammer 1 zwischen dem Mikrowellenfenster 14 und dem Substrathalter 11 erzeugbar. Durch Verschieben der Einheit 3 zur Erzeugung des Magnetfelds ist das Mikrowellenplasma 3, das gleich lokal wie das Kreuzungsvolumen 3 ist, in der Prozesskammer verschiebbar und brennt damit an vorgesehenem Ort.*

*Die Einrichtung zur Erzeugung eines Elektron-Zyklotron-Mikrowellen-Niederdruckplasmas besteht somit aus mit einem Mikrowellenspiegel 16 versehenen Mi*krowellenabstrahlvorrichtung 15, MAV, und der Plasmalokalisierungseinheit 3, PLE, die mit ihrem im Freien verlaufenden Magnetfeld den reflektierten Mikrowellenstrahl an einem vorgebbaren Ort entlang der Strahlachse unter Bildung des Kreuzungsvolumens 13 kreuzt. Im Detail sind das die mikrowellentechnische Baugruppe, die aus einer herkömmlichen, in der Hochfrequenztechnik bekannten Mikrowellenquelle/Elektronenröhre 7 mit Wellenleiter 5 und Abstrahleinrichtung/Antenne 17 besteht *(in der unten stehenden Figuren nicht angedeutet)*, und der Spiegel/Reflektor 16 für die Mikrowelle.

Die schalenartige Reflexionsfläche des Mikrowellenspiegels 16 ist eine offene konische Fläche mit Scheitelpunkt 2 *(wie in der US 5,115,167, dort kann es aufgrund des Solenoiden 3 nur ein Scheitelpunkt sein)* oder Scheitellinie, die einen von der Reflexionsfläche überdeckten reellen Brennpunkt oder eine überdeckte reelle Brennlinie hat.

Im Brennpunkt/auf der Brennlinie ist die Auskopplung für die Mikrowelle auf die Spiegel-/Reflexionsfläche ausgerichtet. Die Reflexionsfläche ist derart, dass sie den im Brennpunkt/auf der Brennlinie ausgekoppelten Mikrowellenstrahl an der Spiegelfläche *bekanntermaßen* zu einem Mikrowellenstrahl 18 mit parallelem - parabolische Reflexionsfläche - oder nahezu parallelem Strahlengang reflektiert. Nahezu parallel heißt, dass der reflektierte Mikrowellenstrahl 18 sowohl leicht konvergieren als auch leicht divergieren kann (Anspruch 2). Unter leichter Konvergenz wird verstanden, dass der Fokus oder Brennpunkt/die Brennlinie 15 des Strahls im ungehinderten Strahlengang außerhalb des Reaktionsvolumens, d. *h. des Kreuzungsvolumens 13, des Mikrowellenplasmas 13,* ist.

Der reflektierte divergente Mikrowellenstrahl 18 soll seinen virtuellen Fokus oder virtuellen Brennpunkt/Brennlinie 15 entsprechend weit hinter der Spiegelfläche haben. Beide Brennpunkte/Brennlinien, der reelle ellipsoide und der virtuelle hyperbolische, sind aber für den Prozess bedeutungslos, sie weisen der Vollständigkeit halber lediglich auf eine am Kegelschnitt geometrisch begründete Konstruktion für den Reflektor hin.

Im Falle des Scheitelpunktes 2 bzw. des Brennpunktes 15 beim Reflektor 16 würde man auch von einem Punktstrahler oder Punktreflektor sprechen, bei der Scheitellinie 2 bzw. der Brennlinie 2, daran anlehnend, von einem Linienstrahler bzw. Linienreflektor.

Die gerade beschriebene Geometrie ist, herstellungstechnisch gesehen, einfach. Die Reflexionsfläche kann durch Rotation um eine Gerade durch den Scheitel- und Brennpunkt erzeugt werden. Dadurch hat der reflektierte Strahl kreisförmigen Querschnitt. Ist der Scheitel der Reflexionsfläche eine gerade Linie und hat damit statt dem Brennpunkt eine entsprechende Brennlinie, wird der Querschnitt des reflektierten Strahlenbündels, abhängig von der Linienlänge, oval bzw. elliptisch bis rechteckig mit oval bzw. elliptisch abgerundeten Ecken, je länger die Brenn- bzw. Scheitellinie ist. Die Reflexionsfläche ist dann allerdings nicht mehr einfach durch Rotation erzeugbar, sondern jetzt durch Rotation um eine Achse senkrecht zur Scheitel- und Brennlinie und einer gleichzeitigen vollen Hin- und Herbewegung entlang der Brenn- bzw. Scheitellinie während einer vollen Umdrehung.

Die Art des der jeweiligen Reflexionsfläche zugrunde liegenden Kegelschnitts bestimmt die Größe des Querschnitts des reflektierten Mikrowellenstrahls. Mit dem flachen parabolischen Reflektor kann ein großer Querschnitt erzeugt werden, mit dem spitzen ein kleiner. Entsprechend beim hyperbolischen. Beim ellipsoiden Reflektor formt die Exzentrizität den Querschnitt des reflektierten Strahls.

Mit dem Substrathalter 10 wird das Substrat 11 mit seiner zu bearbeitenden Fläche in den Strahlengang des reflektierten Mikrowellenstrahls 18 exponiert, bzw. in Position zum Mikrowellenplasma 13 gebracht/geschwenkt.

In der evakuierbaren Prozesskammer 1 ist zumindest der Substrathalter, eventuell auch die Plasmalokalisierungseinheit 3, aufgestellt. Ihre Wand hat als Bestandteil das mikrowellentransparente Fenster 14, durch das der reflektierte Mikrowellenstrahl 18 hindurch in das Kammerinnere auf das exponierte Substrat 11 trifft. Zwischen diesem Mikrowellenfenster 14 und dem Substrathalter 10 kreuzt der Mikrowellenstrahl 18 das Magnetfeld.

Das Mikrowellenfenster 14 kann sich im freien Strahlengang der Mikrowelle von der Auskopplung bis vor dem Magnetfeld befinden. Dieses Fenster ist stets Bestandteil der Wand der Prozesskammer 1, da es die Umgebung vom Innern der Prozesskammer trennt. In der Auskopplungsöffnung für die Mikrowelle hätte *das Mikrowellenfenster 14* den Querschnitt des lichten Querschnitts der Auskoppelöffnung. Hohlleiter 5 samt Reflektor 16 wäre dann Bestandteil der Wand der Prozesskammer 1. Im weitern Strahlengang wäre die Durchgangsfläche des Fensters einfach die, dass der örtliche Strahlquerschnitt stets vollständig darin *läge*.

Der magnetische Fluss jeder Einheit 3 kreuzt den reflektierten Mikrowellenstrahl 18, d. h. die Strahlachse 8 der Mikrowelle kreuzt sich mit der Achse 9 des dortigen Magnetfelds, was im Allgemeinen anzustreben ist, oder beide liegen allenfalls derart windschief zueinander, d.h. sie schneiden sich nicht, gehen aber mit geringem Abstand aneinander vorbei, so dass im Strahlvolumen des reflektierten Mikrowellenstrahls irgendwo Plasmazündung auf jeden Fall noch zustande kommt. Dabei liegen im Falle mehrerer Einheiten 3 zum Erzeugen eines jeweiligen Magnetfelds alle im freien verlaufenden Magnetfelder so zueinander, dass sie im Strahlverlauf der Mikrowelle nicht hintereinander liegen, da ein im Kreuzungsvolumen 3 aus Magnetfeld und Mikrowellenstrahl gezündetes Plasma die Mikrowelle je nach sonstigen Prozesskammerparametern, insbesondere der Gasdichte n, die Mikrowelle absorbiert, zumindest stark absorbiert.

Das Magnetfeld hat im Durchdringungsbereich 13 mit dem Mikrowellenstrahl 18 bauchige Form, so dass es ein Kreuzungsvolumen 13 aus einem Zylinder- oder schwachen Kegelstumpf mit kreisförmigem oder elliptischen/ovalem oder ovalrechteckigem Querschnitt mit diesem Magnetfeldbauch gibt. In diesem jedem Durchdringungs- oder Kreuzvolumen 13 von Mikrowellenstrahl 18 und jeweiligem Magnetfeld gibt es ein Teilvolumen von mindestens $0,5\,cm^3$, in dem das Plasma zündet, sich auf Grund der Bedingungen darin ausdehnt und brennt. Im Strahlvolumen muss irgendwo eine senkrechte Komponente des dortigen Vektors der magnetischen Induktion B zum Wellenvektor k des reflektierten Strahls der Mikrowelle die Elektron-Zyklotron-Resonanz-Bedingung erfüllen. Es ist also nicht verlangt, dass die Magnetfeldachse senkrecht zur Strahlachse der reflektierten Mikrowelle ist, bzw. diese senkrecht schneidet. Der technisch geringste Aufwand oder die technisch einfachste Lösung ist aber wohl der oder die, wenn sich die Magnetfeldachse 9 mit der Strahlachse 8 oder der Strahlachse des in Wechselwirkung tretenden Strahlausschnitts der reflektierten Mikrowelle 18 senkrecht schneidet und die Magnetfeldachse 9 zwischen den Polen bzw. den beiden Spulen von der Strahlachse 8 halbiert wird. Der nicht senkrechte Schnitt ist Maßnahme für eine spezielle technische Lösung. Jede dieser Einheiten ist in Wechselwirkung mit der Mikrowelle und dem Gas im Rezipienten/der Prozesskammer eine Plasmalokalisierungseinheit.

Die Ionen bilden sich aus der Gasfüllung der Prozesskammer. Die Plasmaladungsträgerdichte $n_{Plasma}$ hängt in erster Näherung von der magnetischen Flussdichte, der Frequenz $\omega_E$ der Mikrowelle, der Mikrowellenleistung, dem Gasdruck, der Zusammensetzung des Gases, dem Verhältnis von Saugleistung des Pumpensystems und dem zugeführten Gasfluss, dem Material der Kammer und eventuell weiterer Einwirkungen auf den Prozess ab.

Wird ein Plasma mit einem elektromagnetischen Wechselfeld erzeugt und liegt die Erregerfrequenz $\omega$ in der Nähe der Elektron-Zyklotron Frequenz, kommt es zu der Elektron-Zyklotron-Resonanz (Electron-Cyclotron-Resonance, ECR). Dort zeigt das Plasma dann eine hohe Dichte $n_{Plasma}$ als auch einen hohen Anregungsgrad. Die Elektron-Zyklotron-Frequenz ist

$$\omega_{ez} = e_0/m_e * B,$$

wobei $e_0$ die Elementarladung und $m_e$ die Elektronenmasse ist. An der Stelle $\omega_{ez}$ oder auch noch in der Nähe unterhalb davon lässt sich ein Plasma sehr hoher Teilchendichte $n_{Plasma}$ erzeugen. Die Darstellung des Brechungsindex n, er ist ein Maß für die Plasmaladungsträgerdichte, im Quadrat über der Frequenz $\omega_E$ hat an der Stelle $\omega_{ez}$ eine einfache Polstelle. Nähert sich $\omega_E$ von unten an diese Polstelle, sind immer höhere Plasmaladungsträgerdichten $n_{Plasma}$ erreichbar, im reibungsfreien Fall unendlich. Jenseits dieser Stelle ist der Brechungsindex n im Quadrat zunächst negativ, hat dann einen Nulldurchgang ins Positive und steigt mit weiter zunehmender Frequenz verhalten an. Prinzipiell könnte dieser jenseitige Frequenzbereich oberhalb des Nulldurchgangs auch noch genutzt werden, dürfte aber hinsichtlich der Plasmateilchendichte weniger interessant sein. Die Plasmadichte kann also über dieses Verfahren für den Prozess optimiert gewählt werden.

Wird die Prozesskammer 1 mit dem ausgewählten Gas zur Plasmaerzeugung bis zu einem für den beabsichtigten Prozess vorgegebenen Druck geflutet, kann in einem Teilvolumen des Kreuzungsvolumens 13 das Plasma über die eingestrahlte Mikrowelle 18 gezündet werden.

In den Unteransprüchen 2 bis 17 sind Merkmale festgehalten, die einen Betrieb der Einrichtung qualitativ gut aufrechterhalten. Die in dem Anspruch 2 beschriebenen konischen Formen der Spiegelfläche - parabolisch, ellipsoid und hyperbolisch - wurden schon ausführlich erläutert.

Die Spiegelfläche selbst besteht für eine verlustfreie oder mit tolerablen Verlusten vor sich gehenden Reflexion zumindest aus einem elektrisch gut leitenden Material oder die gesamte Spiegelwand, falls sie metallisch ist, besteht aus einem solchen elektrisch gut leitenden Material. Die bei der Reflexion gegebenenfalls erzeugte Wärme in der Spiegelfläche muss über die Wand an die Umgebung abgeführt werden und geschieht in einfacher Form durch außen mit gutem Wärmekontakt aufgesetzte oberflächenvergrößernde Mittel wie Fahnen oder Wellblechen oder Lammellen (Anspruch 3). Die Wärme wird dann von umgebender oder angeströmter Luft übernommen und abgeführt.

Für Zwangskühlung besser geeignet ist, wenn über der Spiegelaußenwand eine Wand haubenartig unter Spaltbildung darüber gestülpt ist. Die oberflächenvergrößernden Mittel können dabei auch als Distanzhalter in der Form vorhanden sein, dass zumindest ein Strömungskanal besteht. Ob das Kühlmittel gasförmig oder flüssig ist, hängt ab, welche Wärmemenge in welcher Zeit mit welchem technischen Aufwand abgeführt werden soll (Anspruch 4). Im Falle einer metallischen Wand wäre damit gleichzeitig eine mikrowellentechnische Abschottung nach außen vorhanden.

Der Aufbau von Anspruch 1 lässt verschiedene Aufbauten zu. Einer ist, dass die Prozesskammer 1 mit dem Mikrowellenspiegel 16 eine zusammenhängende Wand bildet und das Mikrowellenfenster 14, das Teil der Wand der Prozesskammer 1 ist, die Mikrowelleneinkopplung und damit den Brennpunkt 15 von der Prozesskammer 1 ausschließt (Anspruch 5). Ein anderer ist, dass die Prozesskammer 1 mit dem Mikrowellenspiegel 16 keine unmittelbar gegenständliche Berührung hat *(Anspruch 6)*. Die mikrowellentechnische Abschottung müsste dann extra eingerichtet werden und würde je nach Wandmaterial nur die Abschottung des Volumens zwischen dem Spiegel und der Prozesskammer verlangen, falls die Prozesswand metallische wäre, und die Prozesskammer einschließen, falls die Prozesskammer aus dielektrischem Material wäre.

Ist die Einheit 3 zur Erzeugung des Magnetfelds entlang der Strahlachse 8 des reflektierten Mikrowellenstrahls 18 verschiebbar, lässt sich über diese Möglichkeit das Kreuzungsvolumen 13 und damit das Plasmavolumen 13 beliebig entlang der Strahlachse 8 verfahren. Im Falle mehrerer, im Freien verlaufender Magnetfelder ist es dann die Strahlachse des jeweils in Wechselwirkung tretenden Strahlausschnitts davon (Anspruch 7). Die Kreuzungsvolumina 13 der jeweiligen Wechselwirkung: Mikrowelle - Magnetfeld, liegen, vom Reflektor 16 aus gesehen, immer unverdeckt, also nebeneinander, gestuft versetzt zueinander, aber nicht hintereinander, es soll ja in jedem Kreuzungsvolumen 13 die maximal möglich Mikrowellenenergie eingebracht werden können. Das ist ein erheblicher Vorteil zur Optimierung des vorgesehenen Prozesses an der exponierten Substratoberfläche.

Die jeweilige Einheit zur Erzeugung des Magnetfelds kann sich innerhalb oder außerhalb der Prozesskammer befinden (Anspruch 7). Liegt sie außerhalb, d.h. Spulen und/oder Pole liegen außerhalb der Prozesskammer, besteht nur die weitere Forderung, dass die Wand der Prozesskammer aus nicht magnetischem Material ist. Die Position der Einheit 3 wird letztlich durch konstruktive Gesichtspunkte und insbesondere mit dem Vorteil der leichten Bedienbarkeit und geringen betrieblichen Anfälligkeit festgelegt.

Die Einheit 3 zur Erzeugung des jeweiligen Magnetfelds kann nach Anspruch 8 ein Permanentmagnet sein. Zwischen den Polen geht der reflektierte Mikrowellenstrahl 18 durch und bildet mit dem dort bauchigen, zeitlich konstanten, im Freien verlaufenden Magnetfeld das Kreuzungsvolumen 13. Üblicherweise wird die Magnetfeldachse 9 dort gerade sein, d. h. die jeweilige Stirnfläche der beiden Pole stehen einander senkrecht gegenüber. Über die Gestaltung der Stirnflächen kann die Bauchigkeit des dazwischen verlaufenden Magnetfeldes in Grenzen mehr oder weniger ausgeprägt werden. Im Allgemeinen werden diese beiden Stirnflächen eben sein. Denkbar ist auch eine einfach gekrümmte Magnetfeldachse 9, solange für die Plasmaerzeugung das ausreichend starke Magnetfeld bzw. die magnetische Induktion B in einem Mindestteilvolumen des zugehörigen Kreuzungsvolumens 13 erzeugt werden kann (siehe Erläuterungen zu Anspruch 1 an entsprechender Stelle oben).

In Anspruch 9 sind als Einheit zur Erzeugung des Magnetfelds zwei Spulen genannt, die auf einer gemeinsamen Achse 9 liegen, und zwischen denen der reflektierte Mikrowellenstrahl 18 hindurchgeht. Beispielsweise könnte das eine Anordnung in der Art eines Helmholtzspulenpaares oder eine Modifikation davon sein. Mit Spulen ist ganz allgemein und im Gegensatz zum Permanentmagneten ein zeitlich sich änderndes Magnetfeld anwendbar.

Zur Führung des magnetischen Flusses ist auch eine Spule mit Eisenkern geeignet (Anspruch 10), der einen Spalt aufweist, durch den die reflektierte Mikrowelle 18 hindurchgeht. Der Spalt im Eisenkern kann wie der Raum zwischen den Polen des Permanentmagneten gestaltet werden. Eine technologisch weitere Art einer solchen Einrichtung ist der Aufbau einer solchen aus supraleitenden auch hochtemperatursupraleitenden Komponenten. Dazu gehört aber eine kryotechnische Anlage, um die Temperaturbedingung, das Unterschreiten der Sprungtemperatur $T_c$, für die Supraleitung einstellen zu können. Das ist ein technischer insbesondere technisch konstruktiver Aufwand, der nur dann durchgeführt wird, wenn eventuell ein Prozess das erfordert und nur alleine durch solche eine Technologie realisiert werden kann.

Aus diesem Gedanken heraus leitet sich schließlich die Kombination aus Permanentmagnet und Spulenpaar ab, mit dem das zeitlich schwankende Magnetfeld einfach erzeugt werden kann. Die jeweilige Magnetfeldachse der drei Magnetfelderzeugungskomponenten, das Spulenpaar und der Permanentmagnet, liegen auf einer gemeinsamen Achse. Zwischen den beiden Spulen liegt dann auch der Spalt des Permanentmagneten (Anspruch 11). Es gibt sehr starke Permanentmagnete, mit denen eine kleinvolumige Einheit gebaut werden kann. Solche Materialien sind beispielsweise in den Materialsystemen Samarium-Kobalt oder Neodym-Eisen-Bor zu finden.

Zumindest für Untersuchungs- und Entwicklungsvorhaben ist es vorteilhaft, wenn der in der Prozesskammer verankerte Substrathalter hinreichend Freiheitsgrade der Translation und Rotation hat. Ausreichend für freie Bewegung und Einstellung sind:

zwei translatorische senkrecht zur Strahlachse, ein translatorischer entlang der Strahlachse, ein rotatorischer senkrecht zur Strahlachse und ein rotatorischer in Richtung der Strahlachse (Anspruch 12). Damit kann die exponierte Fläche des Substrats in nahezu jede prozesstaugliche Lage zum einfallenden Mikrowellenstrahl bzw. zum Plasmavolumen gebracht werden. Für einfache, festgelegte Prozesse, z. B. zur Herstellung eines Substrats in hohen Stückzahlen wird diese Vielzahl an Freiheitsgraden sicher überprüft.

Für industrielle Fertigungsprozesse kann der in der Prozesskammer montierte Substrathalter eine revolverartige Einrichtung sein, mit der ein darin eingespanntes Substrat oder eingespannte Substrate jeweils in Position zum Mikrowellenplasma oder zu einem der Mikrowellenplasmen gedreht/geschwenkt werden kann (Anspruch 13). Für eine Rundumprozessierung an der Oberfläche, kann jedes eingespannte Substrat zusätzlich noch um sich selber gedreht werden

Der Spiegel, eigentlich nur seine Reflexionsfläche verlangt für eine möglichst ideale Reflexion eine entsprechende Qualität dieser Reflexionsschicht, nämlich dass mindestens aus einer Schicht oder wenigstens aus Maschendraht mit kleiner Maschenweite gegenüber der Wellenlänge der Mikrowelle und aus elektrisch gut leitenden Material wie Silber, Kupfer, Gold oder Aluminium, Eisen oder legiertem Eisen ist (Anspruch 14). Damit ist diese Reflexionsfläche auch gut wärmeleitend, so dass bei weiterer guter Wärmeleitung dahinter die an der Reflexionsfläche erzeugte Wärme abgeleitet werden kann.

Wie immer der Spiegel aufgebaut ist, für aggressive Atmosphären kann die Reflexionsfläche mit einem gegenüber einer solchen Atmosphäre inertem Dielektrikum dünnschichtig überzogen oder die metallische Oberfläche dafür geeignet metallisch veredelt sein (Anspruch 15), so dass einerseits ein Schutz besteht und im Fall dielektrischer Beschichtung die dielektrischen Verluste gering gehalten werden können.

In Anspruch 16 wird Kohlenstoff noch als Material für die Reflexionsfläche aufgeführt. Damit könnte der Spiegel, die Reflexionsfläche selber, aus Graphit bestehen und mit einer hydrogenisierten Kohlenstoffschicht und/oder einer legierten Kohlenstoffschicht als Schutz- und Funktionsschicht überzogen sein. Der Spiegel kann insgesamt aus einer Kohlefaser, CFK, aufgebaut sein. Das hätte gegenüber Metall Gewichtsvorteile und ermöglichte eine leichte Bauweise bei mindestens ebenso guter Steifigkeit wie bei Metall.

Das Mikrowellenfenster ist eine wichtige Komponente der Einrichtung. Es muss für die Mikrowelle transparent sein. Allenfalls wären vernachlässigbare Verluste bei der Transmission tolerabel. Zwangskühlung dieser Komponente zur Wärmeabfuhr sollte nur, wenn wirklich unumgänglich, eingerichtet werden, da dies stets einen technischen Aufwand bedeutet, der mit Platzbedarf und Kosten einhergeht. Als Fenstermaterial eignet sich Quarzglas oder Aluminiumoxid. Ein ausgezeichnetes Material ist auch Diamant, der aber teuer ist (Anspruch 17). Andere Materialien, die für die Aufgabe hinreichend mikrowellentransparent und mechanisch für den Aufbau geeignet sind, sind nicht ausgeschlossen und von Fall zu Fall in Betracht zu ziehen.

Die mikrowellentechnische Abschirmung nach außen hin kann konstruktiv vielfältig gelöst werden. So kann es eine anlagenumfassende sein, die nur diese Funktion hat. Es kann eine integrierte dadurch sein, dass der Reflektor Teil der Prozesskammerwand ist und beide Teile metallisch sind. Der Reflektor und die Prozesskammerwand sind metallisch, auf jeden Fall elektrisch gut leitend und sind zumindest mit einem mikrowellendichten Gitter rundum miteinander verbunden. Fenster in der Prozesskammerwand müssen mit einem solchen mikrowellendichten Gitter ebenfalls wandkontaktierend belegt sein, falls keine umfassende Abschirmung bestünde.

An vorhandenen Flanschen an der Wand der Prozesskammer können weitere Funktionseinheiten angeflanscht werden, die für den Oberflächen-Behandlungsprozess einzusetzen sind. Die Einrichtung kann mit PVD- und CVD-Beschichtungsquellen kombiniert werden oder Bestandteil von solchen sein (PVD = Physical Vapor Deposition; CVD = Chemical Vapor Deposition). PVD- und CVD-Quellen sind beispielsweise Magnetron-Quellen, Arc-Verdampfer, oder andere Verdampfer-Quellen, wie Widerstands- oder Elektronenstrahl-Verdampfer. Die Einrichtung ist in Kombination mit allen angeflanschten Typen von Ionenkanonen, allen Typen von Plasmastrahlquellen, allen Typen von Ionen-Implantationsquellen und allen Plasma-Ätzeinheiten einbaubar oder als solche einrichtbar. Wenn insbesondere zwischen Quelle und Substrat eine große Distanz erforderlich ist, kann bei einem großen Abstand immer noch ein notwendig intensives Plasma erzeugt werden. Ein solch großer Abstand wird erzwungen, wenn mehrer Quellen für einen Prozess notwendig sind oder mit einer solchen Einrichtung ein Prozess geführt werden muss, an dem mehrere Strahlquellen beteiligt sind, die auf das Substrat gerichtet sind. Am Substrat lässt sich so ein intensives Plasma erzeugen, da nahezu die gesamte einkoppelbare Energie direkt dem Plasma zugeführt wird. Dort liegt dann ein Plasma mit hoher Ionen-, Elektronen- und Radikalteilchendichte vor. Liegt nämlich an der Quelle selbst ein Plasma vor, das sich bis zum Substrat ausdehnt, nehmen darin die Ionen- und Radikalenteilchendichte sowie die durch das Plasma angeregte Teilchendichte zum Substrat hin ab.

Kann mit dem Punktreflektor ein kompaktes Kreuzungsvolumen der Wechselwirkung zustande gebracht werden, so ist mit dem Linienreflektor ein mehr längliches oder beabsichtigt langes Kreuzungsvolumen zu erzeugen. Das ist bei Oberflächenmanipulationsprozessen an länglichen Gegenständen durchaus von Vorteil, da dann auf der exponierten Seite über die Substratlänge hinweg ein zusammenhängendes, gleichmäßiges Mikrowellenplasma erzeugt werden kann. Das kann in Näherung auch mit aneinander gereihten Punktreflektoren erzeugt werden, bedeutet aber eine erhöhten Baukomponentenaufwand insbesondere an Mikrowellenquellen.

Im Folgenden wird die Einrichtung anhand der Zeichnung mit den Figuren 1 bis 4 näher erläutert. Es zeigen:

Figur 1 die Einrichtung schematisch mit parabolischem Reflektor,
Figur 2 die Einrichtung schematisch mit ellipsoidem Reflektor,
Figur 3 die Einrichtung schematisch mit hyperbolischem Reflektor,
Figur 4 die Einrichtung mit Revolversubstrathalter,

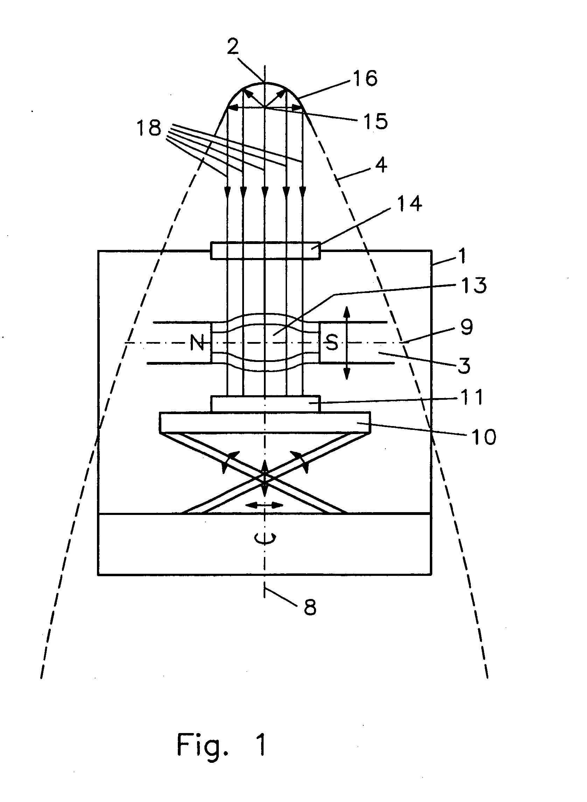

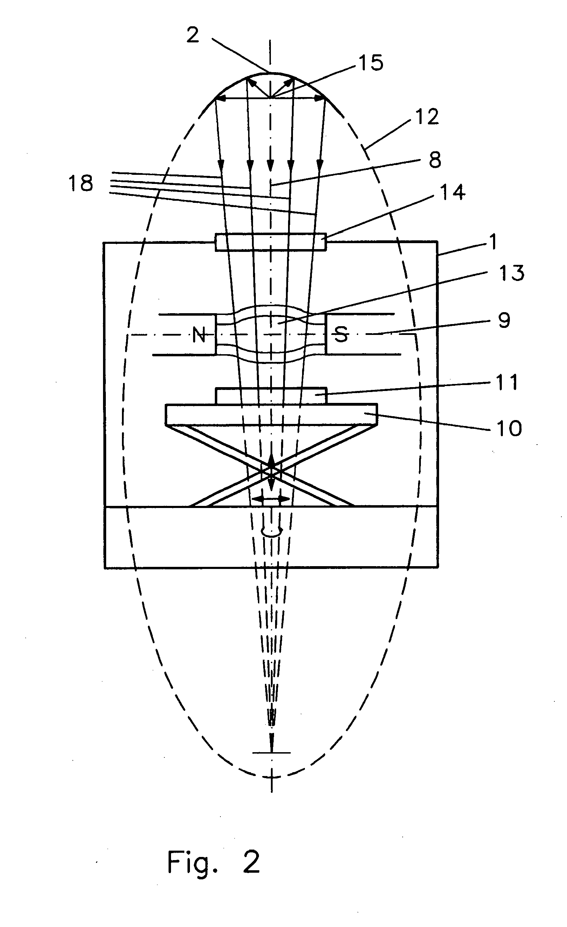

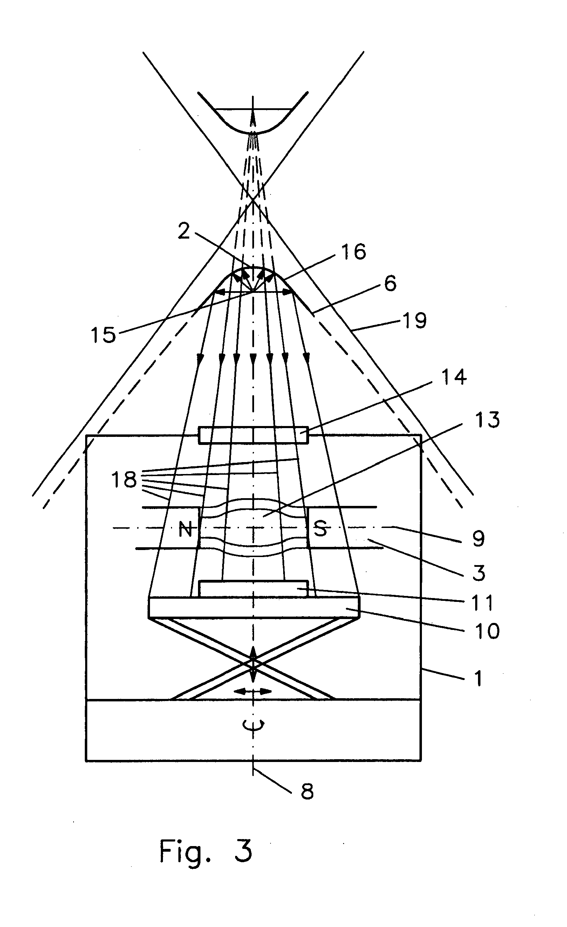

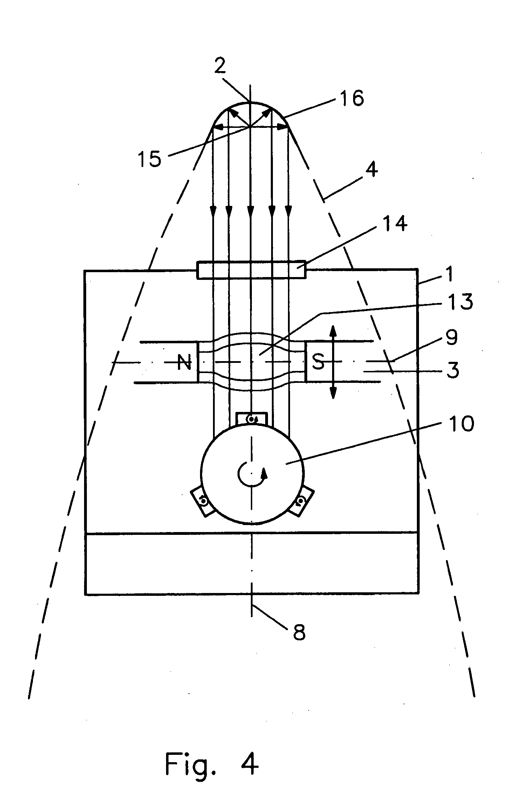

Die Figuren 1 bis 4 zeigen den prinzipiellen Aufbau schematisch in technisch einfachster Form, um das Neue, nämlich die mit einem Mikrowellenspiegel 16 versehene Mikrowellenabstrahlvorrichtung 15, MAV, und die Plasmalokalisierungseinheit 3, PLE, im Gang des reflektierten Mikrowellenstrahl 18, übersichtlich hervorzuheben. Bis auf den Reflektor 16 sind die Figuren 1 bis 3 identisch. Figur 4 hat stellvertretend für die andern den Revolversubstrathalter 10, der in den Figuren 2 und 3 an die entsprechende Stelle treten könnte. Es wird jedes Mal ein Schnitt durch den Scheitel 2 und den Brennpunkt 15 des Reflektors 16 gezeigt. Im Falle der Scheitel- 2 und Brennlinie 15 ginge der Schnitt senkrecht durch diese beiden Linien, bei der Entartung zum Punkt eben durch diese beiden, Scheitelpunkt 2 und Brennpunkt 15. In Figur 1 ist die konischen Innenwand des Reflektors 16 Teil eines Paraboloiden, dargestellt durch die gestrichelt angedeutete Parabel 4.

Im Brennpunkt 15 des Reflektors 16 ist die zum Scheitel 2 gerichtete Auskoppelöffnung der Mikrowelle justiert, so dass nach der Reflexion ideal nur ein paralleler Strahl 18 der Mikrowelle besteht. Mikrowellenquelle 7 und Hohlleiterführung 5 mit Auskopplung 17 am Ende sind nicht dargestellt, da das bekannte Hochfrequenztechnik ist.

Reflektor 16 und Prozesskammerwand sind hier entkoppelt dargestellt - der Reflektor 16 ist kein Bestandteil davon - somit befindet sich das mikrowellendurchlässige Fenster 14 im Bereich des parallelen Strahls 18 der Mikrowelle. Als Spiegel 16 wird hier der parabolische Reflektor eines Autoscheinwerfers verwendet. Zur mikrowellentechnischen Abschottung müssten Prozesskammer 1 und Reflektor 16 von einem elektrisch leitenden Käfig umgeben sein. Im Falle eines Gitters wäre die Maschenweite kleiner $\lambda/4$ der Wellenlänge $\lambda$ der Mikrowelle zu wählen. Ist die Wand der Prozesskammer metallisch und der Reflektor 16 ebenfalls, so würde eine mikrowellendichte Kontaktierung zwischen Reflektor 16 und Prozesskammerwand eine solche Abschottung auch bewirken.

Das Mikrowellenfenster 14 als Zutritt für die Mikrowelle zur Prozesskammer befindet sich im Bereich des parallelen Strahlengangs 18 zwischen Reflektor 16 und vor dem Magnetfeld (siehe Figuren 1 bis 4). Im Durchführungsbeispiel ist das Fenster aus Aluminiumoxid, $Al_2O_3$, oder Quarzglas. Beide Materialien sind für die hier eingesetzte Mikrowelle der Frequenz 2,45 GHz nahezu völlig transparent und daher für den Aufbau gut geeignet. Das Mikrowellenfenster ist hier jeweils als eine ebene Scheibe gezeichnet. In einer von vielen beispielhaften möglichen technischen Ausführung ist es ein Becher, der vakuumdicht direkt über die Mikrowellenauskopplung gestülpt ist.

In der Prozesskammer befindet sich der Substrathalter/-tisch 10, der hier durch eine senkrecht zum Strahl ausgestellte Platte mit Scherengestänge zur Wand der Prozesskammer dargestellt ist. Auf der zum Strahl exponierten Seite des Substrattisches 10 ist das Substrat 11 selber exponiert. Die Pfeile am Tischgebein deuten die möglichen Freiheitsgrade der Verschiebung bzw. Verdrehung/Rotation des Tisches an. Für Laborzwecke ist das vorteilhaft, für industrielle Prozessierung sind nur prozessnotwendige Freiheitsgrade eingerichtet.

Nur den parallelen Teil des Strahlengangs 18 der Mikrowelle kreuzt das Magnetfeld, und zwar bei vorhandenem Mikrowellenfenster 14 zwischen diesem und dem Substrathalter 10, sonst zwischen Reflektor 16 und Substrathalter 10. In diesem Bereich ist das Magnetfeld, d.h. die Einrichtung 3 zur Erzeugung des Magnetfelds, entlang der Achse 8 des parallelen Teils des Mikrowellenstrahls 18 verschiebbar. Diese Erzeugungseinrichtung 3 ist in den Figuren 1 bis 4 lediglich durch die beiden Pole N und S angedeutet. Statt N und S könnte auch nur das Spulenpaar angedeutet sein. Wo die Erzeugungseinrichtung für das Magnetfeld aufgestellt ist, innerhalb des Prozessraumes oder außerhalb, ist eine rein konstruktive Aufgabe. Wichtig ist, dass entlang der Strahlachse der parallelen Mikrowelle das Kreuzungsvolumen, gebildet aus dem Mikrowellenstrahl und dem im Freien verlaufenden Magnetfeld, darin irgendwo die Feldstärke von 875 Gauß bei der Erregerfrequenz $\omega_E$ = 2,45 GHz besteht, damit die Elektron-Zyklotron-Resonanz- (ECR-) Bedingung $\omega_{CE}$, von der Frequenz her gesehen, von unten her annähernd, darin zustande kommt.

*Bezugszeichenliste:*

    1. Prozesskammer
    2. Scheitel, Scheitelpunkt, Scheitellinie
    3. Einrichtung, Plasmalokalisierungseinheit
    4. Parabel
    5. Wellenleiter
    6. Hyperbel
    7. Mikrowellenquelle
    8. Strahlachse der Mikrowelle
    9. Achse des Magnetfelds
    10. Substrathalter, Substrattisch, Revolversubstrathalter
    11. Substrat
    12. Ellipse
    13. Kreuzungsvolumen, Mikrowellenplasma, Durchdringungsbereich
    14. Mikrowellenfenster
    15. Brennpunkt, Brennlinie
    16. Mikrowellenspiegel, Reflektor
    17. Abstrahleinrichtung, Antenne
    18. Mikrowellenstrahl
    19. Asymptote

**Patentansprüche**

1. Einrichtung zur Erzeugung eines Elektron-Zyklotron-Mikrowellen-Niederdruckplasmas in einer Prozesskammer (1), bestehend aus:

    einer Mikrowellenquelle (7) mit Wellenleiter (5) und Abstrahleinrichtung/Antenne (17), einem Mikrowellenspiegel (16), dessen schalenartige Reflexionsfläche Teil einer offenen konischen Fläche mit Scheitelpunkt (2) oder Scheitellinie (2) ist und die einen von dem Mikrowellenspiegel (16) überdeckten Brennpunkt (15) oder überdeckte Brennlinie (15) hat, mit dem der im Brennpunkt (15) oder auf der Brennlinie (15) über die Antenne (17) abgestrahlte Mikrowellenstrahl zu einem Parallelstrahl (18) oder nahezu parallelen, d.h. schwach konvergenten oder schwach divergenten Strahl, reflektiert wird, einem Substrathalter (10) im Strahlengang des am Mikrowellenspiegel (16) reflektierten Mikrowellenstrahls (18), in dem ein eingespanntes Substrat (11) mit ausgesuchter Fläche in den reflektierten Mikrowellenstrahl (18) exponiert wird,

einem mikrowellentransparenten oder die Transmission nicht nennenswert beeinträchtigenden Fenster (14), zwischen Antenne (17) und vor dem Substrathalter (10),

einer evakuierbaren Prozesskammer (1), in der der Substrathalter (10) aufgestellt ist und die als Bestandteil ihrer Wand das Mikrowellenfenster (14) hat, die zur Erzeugung eines Mikrowellenplasmas (13) darin mit einem ausgewählten Gas bis zu einer vorgegebenen Dichte n /einem vorgegebenen Druck p geflutet werden kann,

mindestens einer Einheit (3) zum Erzeugen eines räumlich ausgedehnten Bereichs eines zeitlich konstanten magnetischen Flusses $B_0$ oder eines zeitlich schwankenden magnetischen Flusses $B_0$ + B(t), welcher sich zwischen dem Substrathalter (10) und dem Mikrowellenfenster (14) befindet und dort von dem reflektierten Mikrowellenstrahl (18) in der Prozesskammer (1) durchdrungen wird,

**dadurch gekennzeichnet, dass**:

    die Einheit (3) oder die Einheiten (3) zur Erzeugung des jeweiligen Magnetfelds entlang der Strahlachse (8) des reflektierten Mikrowellenstrahls (18) oder der Strahlachse (8) des in Wechselwirkung tretenden jeweiligen Strahlausschnitts verstellt werden kann oder können,

    die im Freien verlaufende, mindestens eine Magnetfeldachse (9) die Strahlachse (8) des Mikrowellenstrahls (18) kreuzt,

    beim Vorhandensein von mindestens zwei Einheiten (3) zum Erzeugen jeweils eines räumlich ausgedehnten Bereichs eines zeitlich konstanten magnetischen Flusses $B_0$ oder eines zeitlich schwankenden magnetischen Flusses $B_0$ + B(t) die jeweiligen Kreuzungsvolumina (13) aus Magnetfeld und Mikrowellenstrahl im Strahlengang (18) der Mikrowelle nicht hintereinander liegen, im jeweiligen Kreuzun gsvolumen (13) von Mikrowellenstrahl (18) und Magnetfeld die

magnetische Induktion $B_0$ in einem Volumen von mindestens 0,5 cm$^3$ so stark ist, dass die eingestrahlte Mikrowelle (18) mit der Erregerfrequenz $\omega_E$ gleich oder nahezu gleich der Elektron-Zyklotron-Frequenz

$$\omega_{ez} = e_0/m_e \, * \, B$$

ist, mit $e_0$ als der Elementarladung und $m_e$ der Elektronenmasse, und somit die Elektron-Zyklotron-Resonanzbedingung besteht oder nahezu besteht,
in dem mindestens einen Kreuzungsvolumen (13) von Mikrowellenstrahl (18) und Magnetfeld ein lokales ElektronZyklotron-Mikrowellen-Niederdruckplasmas an einem vorgebbaren Ort innerhalb der Prozesskammer (1) zwischen dem Mikrowellenfenster (14) und dem Substrathalter (11) erzeugbar ist.

2. Einrichtung nach Anspruch 1, **dadurch gekennzeichnet, dass**:

   der Mikrowellenspiegel (16) parabolisch oder ellipsoid oder hyperbolisch ist.

3. Einrichtung nach Anspruch 2, **dadurch gekennzeichnet, dass** der Mikrowellenspiegel (14) an seiner Außenfläche zur besseren Wärmeabführung oberflächenvergrößernde, gut wärmeleitende Mittel angebracht hat.

4. Einrichtung nach Anspruch 2, **dadurch gekennzeichnet, dass** der Mikrowellenspiegel (14) über seine Außenfläche eine Haube mit Zu- und Abflussstutzen über Distanzstreifen auf Distanz aufgesetzt hat, die am Spiegelrand dicht anliegt, so das eine kanalartige Spaltfläche besteht, durch die zur besseren Wärmeabführung Kühlmittel strömen kann.

5. Einrichtung nach Anspruch 3 oder 4, **dadurch gekennzeichnet, dass** die Prozesskammer (1) am Rand des Mikrowellenspiegels (16) ansetzt und Mikrowellenfenster (14) die Mikrowelleneinkopplung gegen das Innere des Prozesskammers (1) abdeckt.

6. Einrichtung nach Anspruch 3 oder 4 **dadurch gekennzeichnet, dass** die Prozesskammer (1) mit dem Mikrowellenspiegel (16) keine unmittelbar gegenständliche Berührung hat.

7. Einrichtung nach Anspruch 6, **dadurch gekennzeichnet, dass** sich die jeweilige Einheit (3) zur Erzeugung des Magnetfelds innerhalb oder außerhalb der Prozesskammer (1) befindet.

8. Einrichtung nach Anspruch 6 oder 7, **dadurch gekennzeichnet, dass** die jeweilige Einheit (3) zur Erzeugung des Magnetfelds aus einem Permanentmagneten besteht, dessen beide Pole einander gegenüberstehen und zwischen denen die Achse (8) des reflektierten Mikrowellenstrahls (18) hindurchgeht.

9. Einrichtung nach Anspruch 6 oder 7, **dadurch gekennzeichnet, dass** die jeweilige Einheit (3) zur Erzeugung des Magnetfelds aus zwei gleichartigen auf einer Achse (9), die die Achse (8) des Mikrowellenstrahls (18) schneidet, liegenden Spulen besteht, zwischen denen die Achse (8) des Mikrowellenstrahls (18) hindurch geht.

10. Einrichtung nach Anspruch 6 oder 7, **dadurch gekennzeichnet, dass** die jeweilige Einheit (3) zur Erzeugung des Magnetfelds aus einer Spule mit Eisenkern besteht, der einen Spalt hat, durch den die Achse (8) des Mikrowellenstrahls (18) hindurch geht.

11. Einrichtung nach Anspruch 6 oder 7, **dadurch gekennzeichnet, dass** die jeweilige Einheit (3) zur Erzeugung des Magnetfelds aus einem Spulenpaar und einem Permanentmagneten besteht, wobei die jeweiligen im Freien verlaufenden Magnetfeldachsen (9) der drei felderzeugenden Komponenten auf einer Achse (9) liegen und der Spalt des Permanentmagneten zwischen den beiden Spulen liegt.

12. Einrichtung nach einem der Ansprüche 8 bis 11, **dadurch gekennzeichnet, dass** der in der Prozesskammer (1) montierte Substrathalter (10) fünf Freiheitsgrade der Bewegung hat:

    zwei translatorische senkrecht zur Strahlachse (18),
    einen rotatorischen senkrecht zur Strahlachse (18) und
    einen translatorischen entlang der Strahlachse (18),
    einen rotatorischen in Richtung der Strahlachse (18).

13. Einrichtung nach einem der Ansprüche 8 bis 11, **dadurch gekennzeichnet, dass** der in der Prozesskammer (1) montierte Substrathalter (10) eine revolverartige Einrichtung ist, mit der ein eingespanntes Substrat (11) oder eingespannte Substrate (11), das oder die jeweils in Einspannposition noch zusätzlich um sich drehbar ist oder sind, jeweils in Position zum Mikrowellenplasma (13) oder zu einem der Mikrowellenplasmen (13) gedreht/geschwenkt werden kann.

14. Einrichtung nach den Ansprüchen 12 und 13, **da-**

**durch gekennzeichnet, dass** die Reflexionsfläche des Mikrowellenspiegels (16) aus einer Schicht oder Maschendraht mit kleiner Maschenweite gegenüber der Wellenlänge λ der Mikrowelle und aus gut leitenden Material wie Silber, Kupfer, Gold oder Aluminium, Eisen oder legiertem Eisen ist.

15. Einrichtung nach Anspruch 14, **dadurch gekennzeichnet, dass** die Reflexionsfläche mit einem die Mikrowelle (18) nicht beeinträchtigenden Belag aus gegenüber der berührenden Atmosphäre inertem Material überzogen/veredelt ist.

16. Einrichtung nach den Ansprüchen 12 und 13, **dadurch gekennzeichnet, dass** die Reflexionsfläche aus einer hydrogenisierten Kohlenstoffschicht und/oder einer legierten Kohlenstoffschicht besteht.

17. Einrichtung nach einem der vorangehenden Ansprüche, **dadurch gekennzeichnet, dass** das Mikrowellenfenster (14) aus Quarzglas oder Aluminiumoxid, $Al_2O_3$, oder Diamant oder die Mikrowellentransmission für den Prozess nicht nennenswert behindernden Material ist.

18. Verfahren zur Erzeugung eines lokal vorgebbaren Elektron-Zyklotron-Mikrowellen-Niederdruckplasmas mit einer Einrichtung gemäß den Ansprüchen 1 bis 17, **dadurch gekennzeichnet, dass** in der Prozesskammer (1) der Mikrowellenstrahl zwischen dem Mikrowellenfenster (14) und dem Substrathalter (10) von dem durch die Einrichtung (3) erzeugten Magnetfeld derart durchdrungen wird, dass die dortige Mikrowellenstrahlachse (8) und die Magnetfeldachse (9) gekreuzt werden, wodurch ein lokal begrenztes Kreuzungsvolumen (13) aus Mikrowellenstrahl (18) und Magnetfeld erzeugt wird, in dem Brennbedin gungen für Plasma eingestellt werden können, das Kreuzungsvolumen (13) bei Bewegung der Einrichtung (3) entlang der Mikrowellenstrahlachse (8) verschoben wird.

**Claims**

1. System for generating an electron-cyclotron microwave low-pressure plasma in a processing chamber (1), comprising:

   a microwave source (7) with waveguide (5) and radiating device/antenna (17), a microwave reflector (16), of which the parabolic reflection surface is a part of an open conical surface with vertex (2) or vertex line (2) and which has a focal point (15) or focal line (15) covered by the microwave reflector (16), with which the microwave beam radiated in the focal point (15) or on the focal line (15) via the antenna (17) is reflected to a parallel beam (18) or almost parallel beam, i.e. a slightly convergent or slightly divergent beam, a substrate support (10) in the beam path of the microwave beam (18) reflected at the microwave reflector (16), in which a tensioned substrate (11) with a specific surface is exposed into the reflected microwave beam (18), a window (14) which is microwave-transparent or which does not impair the transmission in any significant way, between the antenna (17) and in front of the substrate support (10), an evacuable processing chamber (1), in which the substrate support (10) is set up, and which has the microwave window (14) as a constituent part of its wall, which, for the generating of a microwave plasma (13), can be flooded with a selected gas up to a predetermined density n /a predetermined pressure p, at least one unit (3) for producing a spatially extended region of a temporally constant magnetic flux $B_0$ or a temporally fluctuating magnetic flux $B_0 + B(t)$, which is located between the substrate support (10) and the microwave window (14), and is penetrated there by the reflected microwave beam (18) in the processing chamber (1),

**characterised in that**:

   the unit (3) or units (3) for generating the respective magnetic field can be displaced along the beam axis (8) of the reflected microwave beam (18) or the beam axis (8) of the respective beam section occurring in reciprocal effect,
   the at least one magnetic field axis (9) extending in the open crosses the beam axis (8) of the microwave beam (18),
   if at least two units (3) are present for generating in each case a spatially extended region of a temporally constant magnetic flux $B_0$ or a temporally fluctuating magnetic flux $B_0 + B(t)$, the respective crossing volumes (13) of magnetic field and microwave beam in the beam path (18) of the microwave do not lie behind one another,
   in the respective crossing volume (13) of microwave beam (18) and magnetic field, the magnetic induction $B_0$ in a volume of at least 0.5 cm$^3$ is so strong that the microwave (18) beamed in with the exciter frequency $\omega_E$ is equal or almost equal to the electron-cyclotron frequency

$$\omega_{ez} = e_0/m_e * B$$

   where $e_0$ is the elementary charge and $m_e$ the electron mass, and therefore the electron-cyclotron resonance condition pertains or almost pertains,

in the at least one crossing volume (13) of microwave beam (18) and magnetic field, a local electron-cyclotron microwave low-pressure plasma can be generated at a predetermined location within the processing chamber (1) between the microwave window (14) and the substrate support (11).

2. System according to claim 1, **characterised in that**: the microwave reflector (16) is parabolic or ellipsoid r hyperbolic.

3. System according to claim 2, **characterised in that** the microwave reflector (14) has good thermally conductive means applied to its outer surface which increase the surface area, for better heat dispersal.

4. System according to claim 2, **characterised in that** the microwave reflector (14) has placed over its outer surface a cover with inflow and outflow nozzles, set at a distance by spacer strips, which is in sealed contact at the edge of the reflector, such that a split surface in the form of a channel is formed through which cooling agent can flow for better heat dispersal.

5. System according to claim 3 or 4, **characterised in that** the processing chamber (1) is located at the edge of the microwave reflector (16) and microwave window (14), which covers the microwave coupling against the interior of the process chamber (1).

6. System according to claim 3 or 4 **characterised in that** the processing chamber (1) does not have any direct material contact with the microwave reflector (16).

7. System according to claim 6, **characterised in that** the respective unit (3) for generating the magnetic field is located inside or outside the processing chamber (1).

8. System according to claim 6 or 7, **characterised in that** the respective unit (3) for generating the magnetic field consists of a permanent magnet, both poles of which are opposed, and between which the axis (8) of the reflected microwave beam (18) passes through.

9. System according to claim 6 or 7, **characterised in that** the respective unit (3) for generating the magnetic field consists of two coils of the same type, located in an axis (9) which intersects the axis (8) of the microwave beam (18), between which the axis (8) of the microwave beam (18) passes through.

10. System according to claim 6 or 7, **characterised in that** the respective unit (3) for generating the magnetic field consists of a coil with an iron core, which has a gap through which the axis (8) of the microwave beam (18) passes.

11. System according to claim 6 or 7, **characterised in that** the respective unit (3) for generating the magnetic field consists of a pair of coils and a permanent magnet, wherein the respective magnetic field axes (9) extending into the open of the three field-generating components lie on one axis (9) and the gap of the permanent magnet lies between the two coils.

12. System according to one of claims 8 to 11, **characterised in that** the substrate support (10) mounted in the processing chamber (1) has five degrees of freedom of movement: Two translatory, perpendicular to the beam axis (18), one rotational perpendicular to the beam axis (18), one translatory along the beam axis (18), and one rotational in the direction of the beam axis (18).

13. System according to one of claims 8 to 11, **characterised in that** the substrate support (10) mounted in the processing chamber (1) is a revolver-type device, with which a tensioned substrate (11) or tensioned substrates (11), which is or are in each case additionally rotatable about one another in the tensioning position, in each case can be rotated/pivoted in position to the microwave plasma (13) or to one of the microwave plasmas (13).

14. System according to claims 12 and 13, **characterised in that** the reflection surface of the microwave reflector (16) is formed of a layer or mesh wire with small mesh widths in relation to the wavelength $\lambda$ of the microwave and of good conductive material such as silver, copper, gold or aluminium, iron or alloyed iron.

15. System according to claim 14, **characterised in that** the reflection surface is coated/refined with a layer which does not impair the microwave (18), made of a material which is inert in relation to the atmosphere in contact with it.

16. System according to claims 12 and 13, **characterized in that** the reflection surface consists of a hydrogenized carbon layer and/or an alloyed carbon layer.

17. System according to one of the foregoing claims, **characterised in that** the microwave window (14) is of quartz glass or aluminium oxide, $Al_2O_3$, or diamond, or a material which does not impede the microwave transmission for the process in any noticeable manner.

**18.** Method for generating a locally specifiable electron-cyclotron microwave low-pressure plasma with a system according to claims 1 to 11, **characterized in that** in the processing chamber (1) the microwave beam between the microwave window (14) and the substrate support (10) is penetrated by the magnetic field generated by the system (3) in such a way that the microwave beam axis (8) there and the magnetic field axis (9) are crossed, as a result of which a locally limited crossing volume (13) of microwave beam (18) and magnetic field is generated, in which focal conditions for plasma can be adjusted, the crossing volume (13) being displaced on movement of the system (3) along the microwave beam axis (8).

**Revendications**

**1.** Dispositif d'obtention d'un plasma basse pression induit par microondes cyclotroniques électroniques dans une chambre de process (1) comprenant :

une source de microondes (7) avec un guide d'onde (5) et un dispositif de rayonnement/antenne (17), un réflecteur de microondes (16) dont la surface de réflexion en forme de coque est une partie d'une surface conique ouverte avec un sommet ponctuel ou linéaire (2), et qui a un foyer ponctuel ou linéaire (15) recouvert par le réflecteur de microondes (16) par lequel le faisceau de microondes diffusé au foyer ponctuel ou linéaire (15) par l'antenne (17) est réfléchi selon un faisceau parallèle (18) ou essentiellement parallèle, c'est-à-dire un faisceau faiblement convergent ou faiblement divergent, un porte substrat (10) situé dans le chemin optique du faisceau de microondes (18) réfléchi sur le réflecteur de microondes (16) dans lequel un substrat (11) encastré ayant une surface sélectionnée est exposé au faisceau de microondes réfléchi (18), une fenêtre transparente aux microondes ou n'affectant pas notamment leur transmission (14), située entre l'antenne (17) et le porte substrat (10), une chambre de process (1) pouvant être mise sous vide, dans laquelle le porte substrat (10) est installé, et comprenant la fenêtre des microondes (14) entant que partie de sa paroi, qui peut être remplie d'un gaz sélectionné jusqu'à une densité n prédéfinie/une pression p prédéfinie, pour permettre d'obtenir un plasma induit par microondes (13), au moins une unité (3) permettant d'obtenir une zone étendue dans l'espace d'un flux magnétique $B_o$ constant dans le temps ou d'un flux magnétique $B_o + B(t)$ variable dans le temps qui est située entre le porte substrat (10) et la fenêtre des microondes (14) et est traversé par le faisceau de microondes (18) réfléchi dans la chambre de process (1),
**caractérisé en ce que**
l'unité (3) ou les unités (3) permettant d'obtenir le champ magnétique respectif peut ou peuvent être déplacé(s) le long de l'axe (8) du faisceau de microondes (18) réfléchi ou de l'axe (8) du secteur respectif du faisceau se présentant en interaction, l'axe (9) du champ magnétique s'étendant à l'extérieur croise l'axe (8) du faisceau de microondes (18) en présence d'au moins deux unités (3) permettant respectivement d'obtenir une zone étendue dans l'espace d'un flux magnétique constant dans le temps $B_o$ ou d'un flux magnétique variable dans le temps $B_o + B(t)$, les volumes de croisement respectifs (13) du champ magnétique et du faisceau de microondes ne sont pas situés les uns derrière les autres dans le chemin optique (18) des microondes,
dans le volume de croisement (13) respectif du faisceau de microondes (18) et du champ magnétique, l'induction magnétique $B_o$ dans un volume d'au moins 0,5 cm$^3$ a une intensité telle que le faisceau de microondes (18) irradié a une fréquence d'excitation $\omega_E$ égale ou essentiellement égale à la fréquence électronique cyclotronique

$$\omega_{EZ} = e_0/m_e * B$$

eo étant la charge élémentaire et $m_e$ la masse électronique, de sorte que l'on soit ainsi en présence ou essentiellement en présence de la condition de résonnance électronique cyclotronique,
dans le volume de croisement (13) du faisceau de microondes (18) et du champ magnétique on peut obtenir un plasma basse pression induit par microondes cyclotroniques électroniques local en un lieu pouvant être prédéfini à la partie interne de la chambre de process (1) entre la fenêtre des microondes (14) et le porte substrat (11).

**2.** Dispositif conforme à la revendication 1,
**caractérisé en ce que**
le réflecteur de microondes (16) est parabolique, ellipsoïdique ou hyperbolique.

**3.** Dispositif conforme à la revendication 2,
**caractérisé en ce que**
sur la surface externe du réflecteur de microondes (14), sont appliqués des moyens bons conducteurs thermiques et augmentant la surface pour permettre une meilleure dissipation thermique.

4. Dispositif conforme à la revendication 2,
**caractérisé en ce que**
sur la surface externe du réflecteur de microondes (14) est monté un capot avec des embouts d'entrée et de sortie qui est maintenu à distance de celle-ci l'intermédiaire de bandes d'écartement et qui s'applique hermétiquement sur le bord du réflecteur de façon à obtenir une surface de clivage en forme de canal dans laquelle un agent de refroidissement peut circuler pour permettre une meilleure dissipation de la chaleur.

5. Dispositif conforme à la revendication 3 ou 4,
**caractérisé en ce que**
la chambre de process (1) est installée au bord du réflecteur de microondes (16) et la fenêtre de microondes (14) recouvre le couplage des microondes par rapport à la partie interne de la chambre de process (1).

6. Dispositif conforme à la revendication 3 ou 4,
**caractérisé en ce que**
la chambre de process (1) n'a aucun contact direct mutuel avec le réflecteur de micrôondes (16).

7. Dispositif conforme à la revendication 6,
**caractérisé en ce que**
l'unité (3) respective permettant d'obtenir le champ magnétique est située à l'intérieur ou à l'extérieur de la chambre de process (1).

8. Dispositif conforme à la revendication 6 ou 7,
**caractérisé en ce que**
l'unité (3) respective permettant d'obtenir le champ magnétique est constituée par un aimant permanent dont les deux pôles sont situés à l'opposé et entre lesquels passe l'axe (8) du faisceau de microondes réfléchi (18).

9. Dispositif conforme à la revendication 6 ou 7,
**caractérisé en ce que**
l'unité (3) respective permettant d'obtenir le champ magnétique est constituée de deux bobines similaires situées sur un axe (9) qui coupe l'axe (8) du faisceau de microondes et entre lesquelles passe l'axe (8) du faisceau de microondes (18).

10. Dispositif conforme à la revendication 6 ou 7,
**caractérisé en ce que**
l'unité (3) respective permettant d'obtenir le champ magnétique est constituée par une bobine ayant un noyau en fer qui comporte un entrefer au travers duquel passe l'axe (8) du faisceau de microondes (18).

11. Dispositif conforme à la revendication 6 ou 7,

**caractérisé en ce que**
l'unité (3) respective permettant d'obtenir le champ magnétique est constituée par une paire de bobines et un aimant permanent, les axes respectifs (a) du champ magnétique (9) s'étendant à l'extérieur des trois composants produisant le champ étant situés sur un axe (9) et l'entrefer de l'aimant permanent étant situé entre les deux bobines.

12. Dispositif conforme à l'une des revendications 8 à 11,
**caractérisé en ce que**
le porte substrat (10) monté dans la chambre de process (1) comporte cinq degrés de liberté de mouvement, à savoir deux degrés de liberté de translation perpendiculaire à l'axe du faisceau (18), un degré de liberté de rotation perpendiculaire à l'axe du faisceau (18), et un degré de liberté de translation le long de l'axe du faisceau (18) ainsi qu'un degré de liberté de rotation en direction de l'axe du faisceau (18).

13. Dispositif conforme à l'une des revendications 8 à 11,
**caractérisé en ce que**
le porte substrat (10) monté dans la chambre de process (1) est un dispositif de type révolver avec lequel au moins un substrat (11) encastré qui est encore en outre mobile en rotation sur lui-même dans la position d'encastrement peut être déplacé par rotation ou pivotement dans sa position par rapport au(x) plasma induit(s) par microondes (13).

14. Dispositif conforme aux revendications 12 et 13,
**caractérisé en ce que**
la surface de réflexion du réflecteur de microondes (16) est obtenue à partir d'une couche ou d'un treillis ayant une ouverture de maille inférieure à la longueur d'ondes lambda des microondes et d'un matériau
bon conducteur tel que l'argent, le cuivre, l'or ou l'aluminium, le fer ou le fer allié.

15. Dispositif conforme à la revendication 14,
**caractérisé en ce que**
la surface de réflexion est recouverte/améliorée par un revêtement n'affectant pas le faisceau de microondes (18) en un matériau inerte par rapport à l'atmosphère environnante.

16. Dispositif conforme aux revendications 12 et 13,
**caractérisé en ce que**
la surface de réflexion est constituée d'une couche de carbone hydrogéné et/ou d'une couche de carbone allié.

17. Dispositif conforme à l'une des revendications précédentes,

**caractérisé en ce que**

la fenêtre des microondes (14) est réalisée en verre quartzeux ou en oxyde d'aluminium, en $Al_2O_3$ ou en diamant, ou en un matériau ne gênant pas notablement la transmission des microondes pour le process.

18. Procédé d'obtention d'un plasma basse-pression induit par microondes cyclotroniques électroniques prédéfini local en utilisant une installation conforme aux revendications 1 à 17,

**caractérisé en ce que**

dans la chambre de process (1) le faisceau de microondes passe, entre la fenêtre de microondes (14) et le porte substrat (10) dans le champ magnétique produit par le dispositif (3) de sorte que l'axe du faisceau du microondes (8) et l'axe du champ magnétique (9) se croisent, avec pour résultat l'obtention d'un volume de croisement (13) limité dans l'espace du faisceau de microondes (18) et du champ magnétique dans lequel des conditions d'obtention d'un plasma peuvent être réglées, le volume de croisement (13) étant décalé par déplacement du dispositif (3) le long de l'axe du faisceau de microondes (8).

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9623318 A

- US 5115167 A